# DEMANDE DE BREVET EUROPEEN

(11) **EP 3 611 804 A1**
(43) Date de publication de la demande: **19.02.2020**
(21) Numéro de dépôt: 19186972.6
(22) Date de dépôt: 18.07.2019
(51) Int. Cl.: H01R 13/115, H01R 12/71

(54) **EQUIPEMENT ELECTRIQUE**

(30) Priorité: 13.08.2018 FR 1857465
(71) Demandeur: Valeo Siemens eAutomotive France SAS, 95800 Cergy (FR)
(72) Inventeur: MORTAIN, Eloi, 92150 SURESNES (FR); HARY, Sébastien, 95340 PERSAN (FR)
(74) Mandataire: Argyma

(57) **Abrégé**

L'invention a pour objet un équipement électrique, notamment destiné à être embarqué dans un véhicule, comprenant une carte électronique (30), un connecteur électrique femelle (40) rapporté sur la carte électronique (30) et configuré pour recevoir une lame (50) de manière à la connecter électriquement avec la carte électronique (30). Ledit connecteur (40) comprend deux pinces (42) en vis-à-vis à distance l'une de l'autre, les deux pinces (42) étant destinées à recevoir ladite lame (50) en venant chacune autour d'une tranche latérale respective de la lame (50).

## Description

### DOMAINE TECHNIQUE ET OBJET DE L'INVENTION

De façon générale, l'invention concerne un équipement électrique comprenant une carte électronique, notamment destiné à être embarqué dans un véhicule automobile, tel qu'un véhicule automobile à moteur électrique ou hybride.

Plus précisément, l'équipement électrique est dédié au contexte d'un véhicule électrique ou hybride entrainé au moins en partie par un moteur électrique.

### ETAT DE LA TECHNIQUE

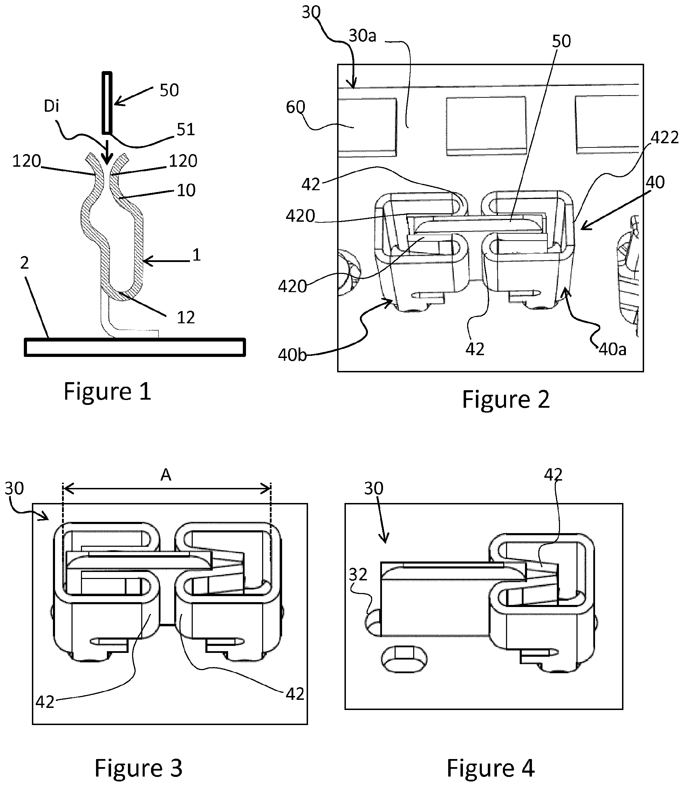

On connait des cartes électroniques recevant des composants électriques, notamment à leur surface. De telles cartes électroniques peuvent être amenées à être connectées électriquement avec un composant électrique comprenant une ou plusieurs bornes électriques en forme de lame. À cet effet, la carte électronique comprend généralement un connecteur rapporté sur la carte et formant un connecteur femelle dans lequel la lame vient s'enficher. Dans les conditions de fabrication industrielle, la direction d'insertion Di est généralement perpendiculaire par rapport à une face de la carte électronique. Il peut y avoir un désalignement entre l'ouverture du connecteur femelle et la lame, qui peut entrainer une impossibilité d'introduire la lame dans le connecteur de la carte électronique de manière suffisante pour une connexion électrique efficace. On connait un connecteur femelle 1 représenté en figure 1 comprenant une pince 10 venant en vis-à-vis d'une tranche extrémale 51 de la lame 50 de manière à compenser un désalignement de la lame dans sa direction d'introduction Di dans le connecteur femelle. Le connecteur 1 permet aussi de gérer un désalignement latéral de la lame 50, c'est-à-dire suivant une direction transversale, notamment perpendiculaire, par rapport à la direction Di d'introduction de la lame 50 dans le connecteur femelle 1. Cependant, ce connecteur 1 ne permet une introduction de la lame 50 que suivant un seul sens le long de la direction Di d'introduction de la lame, c'est-à-dire par le dessus du connecteur 1 tel que représenté en figure 1. Le connecteur 1 ne permet pas d'introduire la lame 50 suivant la même direction Di, mais par le dessous. Or, suivant l'encombrement de l'environnement de la carte électronique 2 ou des composants devant être connectés à la carte électronique 2, il peut être avantageux d'insérer la lame 50 depuis un côté de la carte 2 qui est opposé à celui où s'étend la pince 10.

Il existe donc un besoin pour un équipement électrique dans lequel un connecteur d'une carte électronique permet plusieurs sens d'insertion d'une lame de connexion, notamment suivant une direction perpendiculaire à la carte électronique.

### PRESENTATION GENERALE DE L'INVENTION

A cet effet, l'invention a tout d'abord pour objet un équipement électrique, notamment destiné à être embarqué dans un véhicule, comprenant :
- une carte électronique,
- un connecteur électrique femelle rapporté sur la carte électronique et configuré pour recevoir une lame de manière à la connecter électriquement avec la carte électronique,
ledit connecteur comprenant deux pinces en vis-à-vis à distance l'une de l'autre, les deux pinces étant destinées à recevoir ladite lame en venant chacune autour d'une tranche latérale respective de la lame.

Ainsi, les deux pinces permettent une introduction de la lame dans les deux sens suivant une direction perpendiculaire à la carte électronique. Ainsi, la lame peut venir dans le connecteur depuis un côté de la carte électronique où se trouvent les pinces, ou la lame peut venir dans le connecteur depuis un côté de la carte électronique opposé au côté où se trouvent les pinces pourvu que la carte électronique le permette. Le connecteur selon l'invention permet donc plus de possibilité d'insertion de la lame que dans l'art antérieur. En outre, grâce aux deux pinces, le connecteur électrique femelle est tolérant à un désalignement latéral de la lame par rapport à une position nominale de la lame.

Selon un mode de réalisation, les pinces sont respectivement formées par au moins deux lames ressort en vis-à-vis, configurées de sorte qu'une force de rappel les ramènent l'une vers l'autre.

Selon une variante, les lames ressort sont reliées mécaniquement entre elles par une portion, dite portion de liaison, configurée pour venir en vis-à-vis d'une tranche latérale de la lame.

Selon une variante, les portions de liaison sont séparées par une distance supérieure à la somme d'une largeur de la lame et d'une incertitude de placement latérale de la lame.

Selon un mode de réalisation, le connecteur comprend deux pièces indépendantes positionnées en vis-à-vis sur la carte électronique, chaque pièce indépendante comprenant une des dites pinces.

Selon une variante, lesdites pièces indépendante sont identiques.

Selon un mode de réalisation, la carte électronique comprend un trou traversant configuré pour recevoir la lame, les pinces étant positionnées en périphérie dudit trou de manière à recevoir ladite lame.

Selon un mode de réalisation, l'équipement électrique comprend en outre un composant électrique comportant une borne électrique en forme de lame, et la lame est reçue dans les pinces du connecteur de la carte électronique de manière à être connectée électriquement avec la carte électronique.

Selon un mode de réalisation, l'équipement électrique forme un onduleur configuré pour contrôler une machine électrique.

### PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :
- la figure 1, déjà décrite, représente un exemple de connecteur femelle de l'art antérieur monté sur une carte électronique,
- la figure 2 représente un équipement électrique comprenant une carte électronique et un connecteur selon un exemple de l'invention,
- la figure 3 représente un exemple dans lequel la lame a un désalignement latéral par rapport au connecteur,
- la figure 4 représente l'équipement de la figure 3 sans une des pinces du connecteur,
- la figure 5 représente une lame destinée à venir dans les connecteurs des autres figures.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE DE L'INVENTION

La figure 2 illustre un exemple d'un équipement électrique selon l'invention, qui comprend une carte électronique 30 et un connecteur femelle 40 recevant une lame 50.

La lame 50 est reçue dans le connecteur femelle 40 pour se connecter électriquement avec la carte électronique 30, en particulier suivant une direction Di perpendiculaire à la carte électronique 30. Notamment, au moins une piste électrique de la carte électronique 30 est reliée au connecteur 40 pour le connecter à d'autres composants 60 de la carte électronique 30.

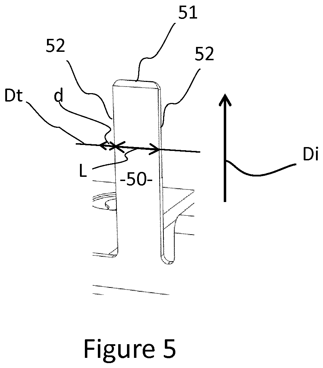

Le connecteur 40 comprend deux pinces 42 qui sont en vis-à-vis l'une de l'autre et à distance l'une par rapport à l'autre. Les deux pinces 42 viennent chacune autour d'une tranche latérale 52 de la lame 50. Les deux pinces 42 permettent de rattraper un désalignement latéral de la lame 50. Autrement dit, les deux pinces 42 permettent de rattraper un désalignement de la lame 50 par rapport à une position nominale, suivant une direction Dt transversale, notamment perpendiculaire par rapport à la direction Di d'introduction de la lame 50 dans le connecteur femelle 40. En faisant référence à la figure 5 qui représente une lame 50 destinée à venir dans le connecteur femelle 40, la direction Dt suivant laquelle le désalignement est rattrapé, peut correspondre à une droite reliant une tranche latérale 52 de la lame 50 à une autre tranche latérale 52 opposée, ladite droite étant perpendiculaire à la direction d'insertion Di.

La figure 3 illustre un cas dans lequel la lame 50 est désalignée par rapport à une position nominale illustrée en figure 2. On constate que les pinces 42 du connecteur 40 conservent un contact électrique avec la lame 50, même lorsque celle-ci est décalée latéralement par rapport à la position nominale. Sans la pince 42 vers laquelle la lame 50 est latéralement décalée, comme par exemple illustré en figure 4, la connexion électrique entre la lame 50 et le connecteur 40 ne se fait que par la pince 42 restante. Or la surface de contact entre la pince 42 restante et la lame 50 peut alors ne pas être suffisante pour un contact électrique efficace entre la lame 50 et la carte électronique 30. En faisant référence à nouveau à la figure 3, grâce à la pince 42 vers laquelle la lame 50 est décalée latéralement, la surface de contact perdue d'un côté du connecteur 40 est compensée par la surface de contact gagnée de l'autre côté du connecteur 40.

Notamment, chaque pince 42 est formée par deux lames ressort 420 qu'une force de rappel ramène l'une vers l'autre. En particulier, les lames 420 d'une pince 42 sont réalisées à partir d'une même feuille découpée et repliée. Notamment, les lames ressort 420 sont liées mécaniquement entre elles par une portion de liaison 422 qui est en vis-à-vis de la tranche latérale 52 de la lame 50. Les portions de liaison 422 peuvent être séparées par une distance A qui est supérieure à la somme d'une largeur L de la lame 50 et d'une incertitude de placement latéral d de la lame 50. Ainsi, les portions de liaison 420 ne limitent pas le positionnement de la lame 50 dans le connecteur femelle 40. Le connecteur femelle 40 est donc adapté pour supporter une incertitude de positionnement latéral de la lame 50. Par exemple, les lames 420 d'une pince 42 peuvent s'étendre parallèlement à la carte électronique 30, notamment à une face de la carte électronique 30, dans leur conformation mettant en oeuvre leur fonction ressort. Pour comparaison, dans le connecteur 1 de l'art antérieur illustré en figure 1, les lames 120 s'étendent perpendiculairement par rapport à la carte électronique 2, dans leur conformation mettant en oeuvre leur fonction ressort.

Les pinces 42 peuvent être formées dans deux pièces indépendantes 40a, 40b, par exemple comme illustré sur les figures 2 à 4. Autrement dit, le connecteur 40 comprend deux pièces 40a, 40b qui sont indépendantes. Les deux pièces 40a, 40b n'ont pas de partie commune et sont liées mécaniquement entre elles par le biais de la carte électronique 30, et éventuellement de la lame 50. En particulier, les pièces 40a, 40b sont identiques. Ainsi, le connecteur 40 peut être obtenu facilement en utilisant deux exemplaires d'un seul type de connecteur, chaque exemplaire recevant une tranche latérale 52 respective de la lame 50. Le connecteur 40, notamment les deux pièces indépendantes 40a, 40b, peuvent être fixés sur la carte électronique 30 par une méthode CMS (pour « Composant Monté en Surface ») ou par une méthode PTP (de l'anglais « Pin Through Paste ») dans laquelle des broches du connecteur 40 ou des pièces indépendantes 40a, 40b sont insérées dans des trous de la carte électronique 30 munis de pâte à braser. La pâte à braser comprend notamment un alliage conducteur.

En outre, le connecteur 40 permet d'insérer la lame 50 suivant la direction Di d'insertion dans les deux sens. Comme cela est par exemple visible en figure 4, la carte électronique 30 peut comprendre un trou traversant 32, sur les bords duquel les pinces 42, en particulier les pièces indépendantes 40a, 40b sont positionnées. Notamment, le connecteur femelle 40 est monté sur une première face 30a de la carte électronique 30. Lorsque la lame 50 est introduite dans le connecteur femelle 40 par la face opposée à la première face 30a de la carte électronique 30, le trou 32 permet un accès dans le connecteur femelle 40. Dans une alternative non représentée, lorsque la lame 50 est introduite dans le connecteur femelle 40 par la première face 30a de la carte électronique 30, le trou 32 permet à la lame 50 de traverser la première face 30a dans le cas où la lame 50 descendrait plus avant dans le connecteur 40 par rapport à une position nominale suivant la direction d'insertion Di. Dans les deux cas, le trou 32 permet un ajustement visuel du positionnement de la lame 50 avec le connecteur femelle 40 lorsque seul est disponible un visuel de la face de la carte qui est opposée à la face de la carte en vis-à-vis de laquelle vient la lame 50.

Par exemple, la lame 50 est une borne de connexion électrique d'un bloc capacitif. La carte électronique 30 est par exemple destinée à réaliser une décharge active du bloc capacitif lors d'un disfonctionnement de l'équipement électrique, ou du véhicule contenant l'équipement électrique.

L'équipement électrique pourrait être un onduleur, notamment un onduleur embarqué dans un véhicule pour contrôler une machine électrique, notamment entrainant le véhicule. Alternativement, l'équipement électrique pourrait être un chargeur électrique configuré pour charger une batterie électrique. Notamment, l'équipement électrique est un chargeur électrique embarqué, couramment désigné par l'homme du métier sous l'acronyme OBC pour « On Board Charger » en anglais, utilisé pour la recharge d'une batterie d'alimentation haute tension du véhicule. L'équipement électrique pourrait encore être un convertisseur continu-continu, notamment embarqué dans un véhicule afin de convertir une tension entre des réseaux électriques basse et haute tension du véhicule.

## Revendications

1. Equipement électrique, notamment destiné à être embarqué dans un véhicule, comprenant :
- une carte électronique (30),
- un connecteur électrique femelle (40) rapporté sur la carte électronique (30) et configuré pour recevoir une lame (50) de manière à la connecter électriquement avec la carte électronique (30),
ledit connecteur (40) comprenant deux pinces (42) en vis-à-vis à distance l'une de l'autre, les deux pinces (42) étant destinées à recevoir ladite lame (50) en venant chacune autour d'une tranche latérale (52) respective de la lame (50).

2. Equipement électrique selon la revendication 1, dans lequel les pinces (42) sont respectivement formées par au moins deux lames ressort (420) en vis-à-vis, configurées de sorte qu'une force de rappel les ramènent l'une vers l'autre.

3. Equipement électrique selon la revendication 2, dans lequel les lames ressort (420) sont reliées mécaniquement entre elles par une portion (422), dite portion de liaison, configurée pour venir en vis-à-vis d'une tranche latérale (52) de la lame (50).

4. Equipement électrique selon la revendication précédente, le connecteur électrique femelle (40) étant configuré pour recevoir une lame (50) ayant une largeur (L), dans lequel les portions de liaison (422) sont séparées par une distance supérieure à la somme de la largeur (L) de la lame (50) et d'une incertitude (d) de placement latérale de la lame (50).

5. Equipement électrique selon l'une quelconque des revendications précédentes, dans lequel le connecteur (40) comprend deux pièces indépendantes (40a, 40b) positionnées en vis-à-vis sur la carte électronique (30), chaque pièce indépendante (40a, 40b) comprenant une des dites pinces (42).

6. Equipement électrique selon la revendication précédente, dans lequel lesdites pièces indépendantes (40a, 40b) sont identiques.

7. Equipement électrique selon l'une quelconque des revendications précédentes, dans lequel la carte électronique (30) comprend un trou (32) traversant configuré pour recevoir la lame (50), les pinces (42) étant positionnées en périphérie dudit trou (32) de manière à recevoir ladite lame (50).

8. Equipement électrique selon l'une quelconque des revendications précédentes, comprenant en outre un composant électrique comportant une borne électrique en forme de lame (50), et dans lequel la lame (50) est reçue dans les pinces (42) du connecteur (40) de la carte électronique (30) de manière à être connectée électriquement avec la carte électronique (30).

9. Equipement électrique selon l'une quelconque des revendications précédentes formant un onduleur configuré pour contrôler une machine électrique.
